# EUROPEAN PATENT APPLICATION

(11) **EP 4 727 321 A1**
(43) Date of publication of application: **15.04.2026**
(21) Application number: 24819388.0
(22) Date of filing: 06.06.2024
(51) Int. Cl.: H10N 50/10, H01L 29/82, H10B 61/00

(54) **TWO-LAYER FILM OF MAGNETIC BODY AND INSULATOR, TUNNEL MAGNETORESISTIVE ELEMENT, AND MAGNETIC MEMORY**

(30) Priority: 09.06.2023 US 202363472069 P
(71) Applicant: JSR Corporation, Tokyo 105-8640 (JP); The University of Tokyo, Bunkyo-ku, Tokyo 113-8654 (JP); Tohoku University, Sendai-shi, Miyagi 980-8577 (JP)
(72) Inventor: TOGA,Yuuta, Tokyo 105-8640 (JP); INUKAI,Kouji, Tokyo 105-8640 (JP); KORETSUNE,Takashi, Sendai-shi, Miyagi 980-8577 (JP); NOMOTO,Takuya, Tokyo 113-8654 (JP); ARITA,Ryotaro, Tokyo 113-8654 (JP); TANAKA,Katsuhiro, Tokyo 113-8654 (JP); MINAMI,Susumu, Tokyo 113-8654 (JP); NAKATSUJI,Satoru, Tokyo 113-8654 (JP)
(74) Representative: Becker, Eberhard
(86) International application number: PCT/JP2024/020707
(87) International publication number: WO 2024/253160

(57) **Abstract**

A two-layer film of a magnetic body and an insulator according to the present invention comprises an antiferromagnetic layer that has a hexagonal crystal structure, with at least one surface thereof being the (10-10) plane of the antiferromagnetic body, and an insulator layer that is composed of two, three, or four kinds of atoms layered on the (10-10) plane. A two-layer film of a magnetic body and an insulator according to the present invention comprises an antiferromagnetic layer that has a hexagonal crystal structure, with at least one surface thereof being the (0001) plane of the antiferromagnetic body, and an insulator layer that is composed of two, three, or four kinds of atoms layered on the (0001) plane. A tunnel magnetoresistive element according to the present invention comprises a second antiferromagnetic film layer that is layered on the insulator of the two-layer film. A magnetic memory according to the present invention comprises a plurality of the tunnel magnetoresistive elements.

## Description

### TECHNICAL FIELD

The present disclosure relates to a two layer film of a magnetic body and an insulator, a tunnel magnetoresistive element, and a magnetic memory.

This application claims priority based on U.S. Provisional Patent Application No. 63/472,069 filed in the United States on June 9, 2023, the contents of which are incorporated herein by reference.

### BACKGROUND ART

A magnetoresistive element is known in which an insulator layer is sandwiched between a ferromagnetic body layer whose magnetization direction can be changed and a ferromagnetic body layer whose magnetization direction is fixed. To increase the speed of such a magnetoresistive element, it has been studied to utilize a layer of an antiferromagnetic body such as Mn₃Sn instead of the ferromagnetic body (see, for example, H. Tsai, et al., "Electrical manipulation of a topological antiferromagnetic state", Nature, volume 580, pages 608-613

(2020)).

WO2022/220251 discloses that by sandwiching Ta between Mn₃Sn and a contact layer of an insulator, the roughness of an interface is suppressed and the interface is smoothed, and a readout signal of a magnetic memory element is enhanced.

In addition, X. Chen, et al., "Octupole-driven magnetoresistance in an antiferromagnetic tunnel junction", Nature 613, 490 (2023) discloses that there is a possibility of obtaining a tunnel magnetoresistive element by exchanging the ferromagnetic body layer for an antiferromagnetic body layer such as Mn₃Sn and sandwiching an insulating layer such as MgO between two antiferromagnetic body layers.

### PRIOR ART DOCUMENTS

### PATENT DOCUMENT

Patent Document 1: WO 2022/220251 A

### NON-PATENT DOCUMENTS

Non-Patent Document 1: H. Tsai, et al., "Electrical manipulation of a topological antiferromagnetic state", Nature, volume 580, pages 608-613 (2020)
Non-Patent Document 2: X. Chen, et al., "Octupole-driven magnetoresistance in an antiferromagnetic tunnel junction", Nature 613, 490 (2023)

### SUMMARY OF THE INVENTION

### PROBLEMS TO BE SOLVED BY THE INVENTION

An object of the present invention is to obtain a two layer film of a magnetic body and an insulator and a tunnel magnetoresistive element with which a relatively large tunnel magnetoresistance ratio can be obtained. Another object is to obtain a magnetic memory with which a relatively large readout signal can be obtained.

### MEANS FOR SOLVING THE PROBLEMS

According to one aspect of the present disclosure, a two layer film of a magnetic body and an insulator has an antiferromagnetic layer having a hexagonal crystal structure and having at least one plane being a (10-10) plane of an antiferromagnetic body and an insulator layer laminated on the (10-10) plane and containing a compound composed of two, three, or four types of atoms.

According to another aspect of the present disclosure, a two layer film of a magnetic body and an insulator has an antiferromagnetic layer having a hexagonal crystal structure and having at least one plane being a (0001) plane of the antiferromagnetic body and an insulator layer laminated on the (0001) plane and containing a compound composed of two, three, or four types of atoms.

According to still another aspect of the present disclosure, a tunnel magnetoresistive element has a second antiferromagnetic film layer laminated on the insulator of the two layer film.

According to still another aspect of the present disclosure, a magnetic memory includes a plurality of the above-described tunnel magnetoresistive elements.

### BRIEF DESCRIPTION OF THE DRAWINGS

A more complete appreciation of the present disclosure and many of the attendant advantages thereof will be readily obtained as the same becomes better understood by reference to the following detailed description when considered in connection with the accompanying drawings.
Fig. 1 is a cross-sectional view illustrating one embodiment of a two layer film of a magnetic body and an insulator.
Fig. 2 is a cross-sectional view illustrating one embodiment of a tunnel magnetoresistive element.
Fig. 3 is a cross-sectional view explaining the operation of a tunnel magnetoresistive element.
Fig. 4 is a circuit diagram of one embodiment of a magnetic memory.

### MODE FOR CARRYING OUT THE INVENTION

In the present description, when an amount, concentration, or other value or parameter is given as a range and/or the description includes a list of upper and lower limit values, this is to be understood as specifically disclosing all integers and fractions within the given range, and all ranges formed from any pair of any upper and lower limit values, regardless of whether or not narrower ranges are individually disclosed. Where a numerical range is recited herein, unless otherwise stated, the range is intended to include not only all integers and fractions within the range, but also endpoints thereof. As one example, a range of 1 to 10 completely describes and includes an independent subrange of 3.4 to 7.2, similar to a list of values of 1, 4, 6, and 10.

In an embodiment of the present disclosure, in a tunnel magnetoresistive element in which an insulator layer is sandwiched between a plurality of antiferromagnetic body layers, a relatively large tunnel magnetoresistance (TMR) ratio can be obtained by use of a specific material for the insulator layer according to a plane orientation of a surface of the antiferromagnetic body layer. Therefore, when the tunnel magnetoresistive element is used in a magnetic memory, a relatively large readout signal is obtained.

Hereinafter, embodiments of each element will be described.

### [Two layer film of magnetic body and insulator and tunnel magnetoresistive element]

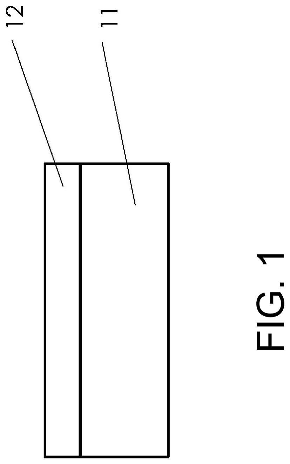

Fig. 1 is a cross-sectional view illustrating one embodiment of a two layer film of a magnetic body and an insulator. An insulator layer 12 is laminated on an antiferromagnetic body layer 11.

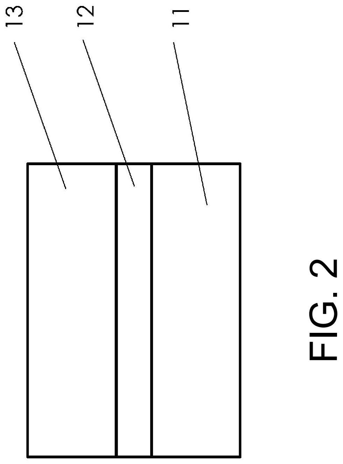

Fig. 2 is a cross-sectional view illustrating one embodiment of a tunnel magnetoresistive element. An insulator layer 12 is laminated on an antiferromagnetic body layer 11, and a second antiferromagnetic body layer 13 is further laminated on the insulator layer 12.

In the two layer film of a magnetic body and an insulator and the tunnel magnetoresistive element of the present disclosure, the materials of the antiferromagnetic body layer 11 and the second antiferromagnetic body layer 13 may be the same or different from each other. Examples of a preferable material include at least one selected from among Mn₃Sn, Mn₃Ge, Mn₃Ga, and Mn₃AₓB₁₋ₓ (A and B are each one selected from among Sn, Ge, and Ga; 0 < x < 1). In these crystals, spins are under cluster magnetic octupolar polarization, and when a magnetic field is applied or an electric current is applied, the net spin polarization defined by a magnetic octupole can be rotated.

When the plane orientation of a surface of the antiferromagnetic body layer 11 in contact with the insulating layer is a (10-10) plane, the material of an insulator laminated on the (10-10) plane is preferably as shown in Table 1, and when the plane orientation of a surface of the antiferromagnetic body layer 11 in contact with the insulating layer is a (0001) plane, the material of an insulating layer laminated on the (0001) plane is preferably as shown in Table 2.

A more preferable material of the insulator layer 12 when the plane orientation of the surface of the antiferromagnetic body layer 11 in contact with the insulating layer is a (10-10) plane is as shown in Table 3, and a more preferable material of the insulator layer 12 when the plane orientation of the surface of the antiferromagnetic body layer 11 in contact with the insulating layer is a (0001) plane is as shown in Table 4.

**[Table 1]**

| Number | Chemical formula | Space group | Number | Chemical formula | Space group |
|---|---|---|---|---|---|
| 1 | BeTe | F-43m | 41 | SrHfO₃ | Pm-3m |
| 2 | YbSe | Fm-3m | 42 | NaTaO₃ | P4/mbm |
| 3 | PbF₂ | Fm-3m | 43 | Na₂PdC₂ | P-3m1 |
| 4 | GeO₂ | P4_2/mnm | 44 | Mg₃(BO₃)₂ | Pnnm |
| 5 | PtO₂ | P-3ml | 45 | Li₂SiO₃ | Cmc2_1 |
| 6 | ThO₂ | Fm-3m | 46 | BaTiO₃ | R3m |
| 7 | Surfs | Fm-3m | 47 | SrTiO₃ | Pm-3m |
| 8 | BN | P6_3/mmc | 48 | KNbO₃ | Amm2 |
| 9 | LiF | Fm-3m | 49 | BaTiO₃ | Amm2 |
| 10 | Li₂S | Fm-3m | 50 | CaTiO₃ | Pm-3m |
| 11 | ZnSe | F-43m | 51 | LiSi₂N₃ | Cmc2_1 |
| 12 | MgO | Fm-3m | 52 | KZnF₃ | Pm-3m |
| 13 | PtO₂ | Pnnm | 53 | TiCoSb | F-43m |
| 14 | BaO | Fm-3m | 54 | BaTiO₃ | P4mm |
| 15 | LiC | Immm | 55 | LiSiNO | Pca2_1 |
| 16 | CaSe | Fm-3m | 56 | KNbO₃ | R3m |
| 17 | TiO₂ | Pbcn | 57 | BeO | P4_2/mnm |
| 18 | FeS₂ | Pnnm | 58 | Mg₃NF₃ | Pm-3m |
| 19 | BN | F-43m | 59 | SbOF | Pnma |
| 20 | CaS | Fm-3m | 60 | ZnF₂ | Pbcn |
| 21 | YbS | Fm-3m | 61 | K₂ReF₆ | P-3ml |
| 22 | AlAs | F-43m | 62 | K₂GeF₆ | P-3ml |
| 23 | Li₂Se | Fm-3m | 63 | BeSiN₂ | Pna2_1 |
| 24 | CdS | F-43m | 64 | K₂PdF₆ | P-3ml |
| 25 | BeO | P6_3mc | 65 | BN | P6_3/mmc |
| 26 | BN | P6_3mc | 66 | HgF₂ | Fm-3m |
| 27 | CaF₂ | Fm-3m | 67 | MgAlBO₄ | Pnma |
| 28 | BeAl₂O₄ | Pnma | 68 | TeO₂ | P2_12_12_1 |
| 29 | NaNbO₃ | Pm-3m | 69 | RbMgF₃ | Pm-3m |
| 30 | SrZrO₃ | Pm-3m | 70 | KF | Pm-3m |
| 31 | KMgF₃ | Pm-3m | 71 | Li₃BN₂ | P4_2/mnm |
| 32 | KTaO₃ | Pm-3m | 72 | LiZnAs | F-43m |
| 33 | K₂PtF₆ | P-3m1 | 73 | LiBC | P6_3/mmc |
| 34 | BaZrO₃ | Pm-3m | 74 | NbFeSb | F-43m |
| 35 | Mg₂PN₃ | Cmc2_1 | 75 | LiZnP | F-43m |
| 36 | K₂TiF₆ | P-3m1 | 76 | BaLiF₃ | Pm-3m |
| 37 | KCuO₂ | Cmcm | 77 | ScF₃ | Pm-3m |
| 38 | NaTaO₃ | Pm-3m | 78 | GeO₂ | Pbcn |
| 39 | KNbO₃ | P4mm | 79 | NbAgO₃ | Pm-3m |
| 40 | NaNbO₃ | P4/mbm | 80 | Li₃PO₄ | Pmn2_1 |
| 81 | ZnAgF₃ | Pm-3m | 121 | InHO₂ | Pmn2_1 |
| 82 | BeF₂ | P3_121 | 122 | FeHO₂ | Pmn2_1 |
| 83 | LaCrO₃ | Pm-3m | 123 | NiO₂ | P-3m1 |
| 84 | MgWO₄ | P2/c | 124 | SnO | Pmn2_1 |
| 85 | ZnWO₄ | P2/c | 125 | KNO₂ | Cm |
| 86 | NiO | Fm-3m | 126 | SrSnO₃ | Pm-3m |
| 87 | NdCrO₃ | Pm-3m | 127 | LaFeO₃ | Pm-3m |
| 88 | Mn₃(BO₃)₂ | Pnnm | 128 | MoF₃ | Pm-3m |
| 89 | FeWO₄ | P2/c | 129 | RbNa₂AuO₂ | Pnnm |
| 90 | WO₃ | P4/nmm | 130 | KMnF₃ | Pm-3m |
| 91 | TiPbO₃ | Pm-3m | 131 | UCOs | Pmmn |
| 92 | TiPbO₃ | P4mm | 132 | CoF₂ | P4_2/mnm |
| 93 | NaVF₃ | Pm-3m | 133 | GdSI | Pmmn |
| 94 | PbO | Pbcm | 134 | RbVF₃ | Pm-3m |
| 95 | NiWO₄ | P2/c | 135 | Li₂CO₃ | P6_3/mcm |
| 96 | HfPbO₃ | Pm-3m | 136 | FeF₂ | P4_2/mnm |
| 97 | NaCl | Fm-3m | 137 | KVF₃ | Pm-3m |
| 98 | CsCl | Pm-3m | 138 | KrF₂ | P4_2/mnm |
| 99 | TlBr | Pm-3m | 139 | KNa₂AuO₂ | Pnnm |
| 100 | LiI | Fm-3m | 140 | ScF₃ | R32 |
| 101 | NaBr | Fm-3m | 141 | NaMgF₃ | Pm-3m |
| 102 | AgCl | Fm-3m | 142 | SeO₂ | Pmc2_1 |
| 103 | AgBr | Fm-3m | 143 | KCrF₃ | P4/mmm |
| 104 | RbCl | Pm-3m | 144 | LiB₆C | Amm2 |
| 105 | RbBr | Pm-3m | 145 | AgBr | P2_1/m |
| 106 | SrH₂ | P6_3/mmc | 146 | SrAlSiH | P3ml |
| 107 | H₄CN₂O | P-42_1 m | 147 | KBr | Pm-3m |
| 108 | GaHO₂ | Pmn2_1 | 148 | BaAlSiH | P3m1 |
| 109 | LiHO | P4/nmm | 149 | InHO₂ | Pnnm |
| 110 | CrHO₂ | Pmn2_1 | 150 | GaHO₂ | Pnma |
| 111 | MnO₂ | P-3ml | 151 | Ba₂MgH₆ | P-3m1 |
| 112 | LuSBr | Pmmn | 152 | HgH₂NCl | Pmma |
| 113 | ErSCl | Pmmn | 153 | Sr₂MgH₆ | P-3m1 |
| 114 | K₂PdF₄ | C2/m | 154 | BN | Fmm2 |
| 115 | RbH₃O₂ | Cmc2_1 | 155 | KNbO₃ | Pm-3m |
| 116 | ErSeI | Pmmn | 156 | SrAlGeH | P3m1 |
| 117 | Li₃BrO | Pm-3m | 157 | KH₄O₂F | Pmc2_1 |
| 118 | DySBr | Pmmn | 158 | CuI | Cmcm |
| 119 | DvSI | Pmmn | 159 | TiGePt | F-43m |
| 120 | UCO₅ | Imm2 | 160 | HoSI | Pmmn |
| 161 | Li₂PNO₂ | Cmc2_1 | 170 | LaGaO₃ | Pm-3m |
| 162 | ZrPbO₃ | Pm-3m | 171 | LaF₃ | Pmmn |
| 163 | GeO₂ | Pnnm | 172 | BaBClF₄ | Pmn2_1 |
| 164 | CO₂ | Cmce | 173 | BaGaH₅ | P2_1 |
| 165 | Na₂TcF₆ | P-3ml | 174 | SrH₂ | Cmcm |
| 166 | Mg(BC)₂ | Pnnm | 175 | SrHN | Pnma |
| 167 | K₂TcF₆ | P-3ml | 176 | BeCr₂O₄ | Pnma |
| 168 | GeF₂ | Pnma | 177 | BaAlGeH | P3m1 |
| 169 | ZnMoO₄ | P2/c | | | |

**[Table 2]**

| Number | Chemical formula | Space group | Number | Chemical formula | Space group |
|---|---|---|---|---|---|
| 1 | TiO₂ | 14 1/amd | 41 | TbPO₄ | 14_1/amd |
| 2 | AlF₃ | R-3c | 42 | KNbO₃ | P4mm |
| 3 | GeO₂ | P4_2/mnm | 43 | TINO₂ | P3_121 |
| 4 | PtO₂ | P-3m1 | 44 | Si₂N₂O | Cmc2_1 |
| 5 | AlN | P6_3mc | 45 | Cd₂SiO₄ | Fddd |
| 6 | NaF | Fm-3m | 46 | BaCO₃ | R3m |
| 7 | GaN | P6_3mc | 47 | HfSiO₄ | I4_1/amd |
| 8 | BN | P6_3/mmc | 48 | TaBO₄ | I4_1/amd |
| 9 | LiF | Fm-3m | 49 | Li₂SiO₃ | Cmc2_1 |
| 10 | YbO | Fm-3m | 50 | BaTiO₃ | R3m |
| 11 | MgO | Fm-3m | 51 | YPO₄ | I4_1/amd |
| 12 | BP | F-43m | 52 | AlAsO₄ | P3_121 |
| 13 | Be₂C | Fm-3m | 53 | SrTiO₃ | Pm-3m |
| 14 | BN | F-43m | 54 | KNbO₃ | Amm2 |
| 15 | Li₂O | Fm-3m | 55 | LaAlO₃ | Pm-3m |
| 16 | ZnO | F-43m | 56 | AlPO₄ | P2_1 |
| 17 | ZnO | P6_3mc | 57 | DyPO₄ | I4_1/amd |
| 18 | ZnO | Fm-3m | 58 | BaTiO₃ | Amm2 |
| 19 | BeO | P6_3mc | 59 | CaTiO₃ | Pm-3m |
| 20 | BN | P6_3mc | 60 | LiScO₂ | 14_1/amd |
| 21 | TiO₂ | P4_2/mnm | 61 | LiSi₂N₃ | Cmc2_1 |
| 22 | LuPO₄ | I4_1/amd | 62 | KZnF₃ | Pm-3m |
| 23 | AlCuO₂ | P6_3/mmc | 63 | TmPO₄ | I4_1/amd |
| 24 | NaNbO₃ | Pm-3m | 64 | BaTiO₃ | P4mm |
| 25 | Na₂SO₄ | Cmcm | 65 | LiCaAlF₆ | P-31c |
| 26 | Li₂ZrN₂ | P-3m1 | 66 | KLiSO₄ | P6_3 |
| 27 | KMgF₃ | Pm-3m | 67 | KLiBeF₄ | P6_3 |
| 28 | KTaO₃ | Pm-3m | 68 | KLiSO₄ | Cc |
| 29 | ScCuO₂ | P6_3/mmc | 69 | LiAlSiO₄ | P6_422 |
| 30 | NaNbO₂ | P6_3/mmc | 70 | SrLiAlF₆ | P-31c |
| 31 | K₂PtF₆ | P-3m1 | 71 | KLiSO₄ | P31c |
| 32 | BaAl₂O₄ | P6_322 | 72 | SiO₂ | P6_222 |
| 33 | LiNbO₂ | P6_3/mmc | 73 | Be₃N₂ | P6_3/mmc |
| 34 | Mg₂PN₃ | Cmc2_1 | 74 | SiO₂ | P6_3/mmc |
| 35 | K₂TiF₆ | P-3ml | 75 | SiC | P6_3mc |
| 36 | ErPO₄ | I4 _1/amd | 76 | KNbO₃ | R3m |
| 37 | HoPO₄ | I4_1/amd | 77 | InPO₄ | Cmcm |
| 38 | NaTaO₃ | Pm-3m | 78 | BeO | P4_2/mnm |
| 39 | Ge₂N₂O | Cmc2_1 | 79 | SiO₂ | C222_1 |
| 40 | ScPO₄ | I4_1/amd | 80 | CsCu₃S₂ | P-3ml |
| 81 | K₂GeF₆ | P-3m1 | 121 | TlPO₄ | Cmcm |
| 82 | PtO₂ | P6_3mc | 122 | Al₄CO₄ | Cmc2_1 |
| 83 | K₂PdF₆ | P-3m1 | 123 | ZnAgF₃ | Pm-3m |
| 84 | BN | P6_3/mmc | 124 | K₂GeF₆ | P6_3mc |
| 85 | AlF₃ | Pm-3m | 125 | NaGe₂N₃ | Cmc2_1 |
| 86 | SiC | F-43m | 126 | Li₂GeO₃ | Cmc2_1 |
| 87 | NaBe₄SbO₇ | P6_3mc | 127 | AlTl(MoO₄)₂ | P-3m1 |
| 88 | NaHgPO₄ | Cmcm | 128 | RbLiCrO₄ | P31c |
| 89 | KAlSiO₄ | P6_3 | 129 | Na₂CrO₄ | Cmcm |
| 90 | RbMgF₃ | Pm-3m | 130 | CrCdO₄ | Cmcm |
| 91 | CsF | Pm-3m | 131 | Cr₂SiO₄ | Fddd |
| 92 | CdSO₄ | Cmcm | 132 | NiSeO₄ | Cmcm |
| 93 | NbBO₄ | I4_1/amd | 133 | LaCrO₃ | Pm-3m |
| 94 | Cd(SbO₃)₂ | P-31m | 134 | BaNiO₂ | Cmcm |
| 95 | PtF₄ | Fdd2 | 135 | SrMnO₃ | P6_3/mmc |
| 96 | NaSi₂N₃ | Cmc2_1 | 136 | NiO | Fm-3m |
| 97 | Ca₂PN₃ | Cmce | 137 | Na₂FeO₄ | Cmcm |
| 98 | LiAlPdF₆ | P-31c | 138 | NdCrO₃ | Pm-3m |
| 99 | Ca(SbO₃)₂ | P-31m | 139 | LiMnVO₄ | Cmcm |
| 100 | Sr(SbO₃)₂ | P-31m | 140 | FePO₄ | P3_121 |
| 101 | Ba(SbO₃)₂ | P-31m | 141 | MgCrO₄ | Cmcm |
| 102 | TiO₂ | Pnma | 142 | CoO | P6_3mc |
| 103 | LiBC | P6_3/mmc | 143 | BaNiO₃ | P6_3/mmc |
| 104 | KAlSiO₄ | P31c | 144 | K₃NaCr₂O₈ | P-3ml |
| 105 | Li₂CN₂ | I4/mmm | 145 | BaNiO₃ | P6_3mc |
| 106 | LiYbAlF₆ | P-31c | 146 | RbLiCrO₄ | P6_3 |
| 107 | BaLiF₃ | Pm-3m | 147 | Li₂WO₄ | C2/c |
| 108 | Zn(ReO₄)₂ | P-3 | 148 | Li₂MnO₂ | P-3ml |
| 109 | Na₂GeTeO₆ | P-31c | 149 | NaCaVO₄ | Cmcm |
| 110 | SrGeTeO₆ | P312 | 150 | Li₂NiO₂ | P-3m1 |
| 111 | K₂CO₃ | P6_3/mmc | 151 | KAl(MoO₄)₂ | P-3ml |
| 112 | ScF₃ | Pm-3m | 152 | PrCrO₃ | Pm-3m |
| 113 | SiO₂ | P6_422 | 153 | CrHgO₄ | Cmcm |
| 114 | Rb₂PdC₂ | P-3m1 | 154 | WO₃ | Pm-3m |
| 115 | Rb₂PtC₂ | P-3m1 | 155 | VCrO₄ | Cmcm |
| 116 | Mg(BeN)₂ | P-3m1 | 156 | NaVCdO₄ | Cmcm |
| 117 | MgSeO₄ | Cmcm | 157 | TiPbO₃ | Pm-3m |
| 118 | NbAgO₃ | Pm-3m | 158 | NdCoO₃ | Pm-3m |
| 119 | LiCaGaF₆ | P-31c | 159 | Na₂CO₃ | P6_3/mmc |
| 120 | K₂SiF₆ | P6_3mc | 160 | Ga₂PbO₄ | Ama2 |
| 161 | Sb₂PbO₆ | P-31m | 201 | CoSeO₄ | Cmcm |
| 162 | NaMnO₂ | Pmmn | 202 | LaFeO₃ | Pm-3m |
| 163 | RhF₃ | P321 | 203 | CsCu₃O₂ | P-3ml |
| 164 | Na₂SO₃ | P-3 | 204 | K₂Al₂Sb₂O₇ | P-3ml |
| 165 | Al₂PbO₄ | Ama2 | 205 | Na₅MoNO₄ | Cmcm |
| 166 | Na₂PtO₂ | Immm | 206 | Li₂Mn₂NiO₆ | Cmce |
| 167 | BaSr(FeO₂)₄ | P-31m | 207 | LiCaCoF₆ | P-31c |
| 168 | VInO₄ | Cmcm | 208 | SiO₂ | Cc |
| 169 | K₃Na(SO₄)₂ | P-3m1 | 209 | MnSeO₄ | Cmcm |
| 170 | SmCoO₃ | Pm-3m | 210 | KNaSO₄ | P-3m1 |
| 171 | TlBr | Pm-3m | 211 | SiO₂ | P2_1 |
| 172 | LiIO₃ | P6_3 | 212 | KAs₄ClO₆ | P6/mmm |
| 173 | KAs₄BrO₆ | P6/mmm | 213 | Rb₂Al₂Sb₂O₇ | P-3m1 |
| 174 | KAs₄IO₄ | P6/mmm | 214 | LiCaCrF₆ | P-31c |
| 175 | TlCl | Pm-3m | 215 | Li₂SO₄ | Cmcm |
| 176 | KCl | Pm-3m | 216 | KNaSO₄ | P3m1 |
| 177 | RbCl | Pm-3m | 217 | LiAlSiO₄ | P6_222 |
| 178 | Mg(AlH₄)₂ | P-3m1 | 218 | SiO₂ | P6_322 |
| 179 | Mg₃Si₂H₄O₉ | P31m | 219 | ScF₃ | R32 |
| 180 | Mn(HO)₂ | P-3m1 | 220 | Al₂O₃ | R-3c |
| 181 | GaHO₂ | Pmn2_1 | 221 | FeBiO₃ | R3c |
| 182 | ZrP₂(HO₃)₂ | P-3ml | 222 | Al₂ZnO₄ | Fd-3m |
| 183 | CrHO₂ | Pmn2_1 | 223 | MgAl₂O₄ | Fd-3m |
| 184 | MnO₂ | P-3m1 | 224 | LiCoO₂ | R-3m |
| 185 | Li₈CoO₆ | P6_3cm | 225 | LaGaO₃ | R-3c |
| 186 | K₂PdF₄ | C2/m | 226 | Si(NiO₂)₂ | Fd-3m |
| 187 | Li₈GeO₆ | P6_3cm | 227 | Mg₂SiO₄ | Fd-3m |
| 188 | Li₈SiO₆ | P6_3cm | 228 | MoS₂ | P6_3/mmc |
| 189 | Li₃BrO | Pm-3m | 229 | FeCuO₂ | R-3m |
| 190 | BaReH₉ | P6_3/mmc | 230 | MoSe₂ | P6_3/mmc |
| 191 | CsAl(MoO₄)₂ | P-3ml | 231 | Sr₃(PO₄)₂ | R-3m |
| 192 | Cs₂PdC₂ | P-3m1 | 232 | K₂S | P6_3/mmc |
| 193 | Cs₂PtC₂ | P-3m1 | 233 | PNF₂ | Cmc2_1 |
| 194 | MnVCuO₄ | Cmcm | 234 | K₂MnF₆ | P6_3mc |
| 195 | NiO₂ | P-3m1 | 235 | AlPO₄ | P6_422 |
| 196 | BaCO₃ | P6_3/mmc | 236 | LiMgVO₄ | Cmcm |
| 197 | AlPO₄ | P6_3mc | 237 | NaMgF₃ | Pm-3m |
| 198 | RbGeIO₆ | P312 | 238 | BaZr(PO₄)₂ | P-3m1 |
| 199 | MgO | P6_3mc | 239 | CaCO₃ | C2 |
| 200 | KNiIO₆ | P312 | 240 | Na₄CoAuO₅ | Cmcm |
| 241 | GdBO₃ | Pb_3/mmc | 274 | KCrO₂ | P6_3/mmc |
| 242 | Li₄Ca₃(SiN₃)₂ | C2/m | 275 | ScAlCO | P6_3mc |
| 243 | FeP₄ | C222_1 | 276 | K₂TcF₆ | P-3ml |
| 244 | LiB₆C | Amm2 | 277 | CsFe(MoO₄)₂ | P-3 |
| 245 | FeP₄ | C2/c | 278 | LaGaO₃ | Pm-3m |
| 246 | Ga₂Os | Fddd | 279 | VO₂ | C2/m |
| 247 | KBr | Pm-3m | 280 | Zn₂PN₃ | Cmc2_1 |
| 248 | GaHO₂ | Pnma | 281 | AlF₃ | P321 |
| 249 | ZrP₂(HO₃)₂ | P-3 | 282 | Sr₃Ta₂ZnO₉ | P-3m1 |
| 250 | Ba₃(H₆Ir)₂ | P-3m1 | 283 | Sr₃MgTa₂O₉ | P-3ml |
| 251 | Ba₂MgH₆ | P-3ml | 284 | MgVCuO₄ | Cmcm |
| 252 | GaH₃NF₃ | Aem2 | 285 | Rb₃Lu(PO₄)₂ | P-3ml |
| 253 | Sr₂MgH₆ | P-3m1 | 286 | Rb₃Er(PO₄)₂ | P-3ml |
| 254 | BN | Fmm2 | 287 | CaH₂F₄ | Fddd |
| 255 | TiH₈(NF₃)₂ | P-3ml | 288 | BaCo₂(PO₄)₂ | P-3 |
| 256 | Rb₂S | P6_3/mmc | 289 | Li₂H₆PtO₆ | P-3 |
| 257 | MgMoN₂ | P6_3/mmc | 290 | LaCrTeO₆ | P-31c |
| 258 | NaCoO₂ | P6_3/mmc | 291 | YCrTeO₆ | P-31c |
| 259 | KNbO₃ | Pm-3m | 292 | TbCrTeO₆ | P-31c |
| 260 | SiO₂ | P2_1 | 293 | DyCrTeO₆ | P-31c |
| 261 | K₄Hf₅O₁₂ | P-3ml | 294 | HoCrTeO₆ | P-31c |
| 262 | K₂PtC₂ | P-3m1 | 295 | YbH₃CN₃ | P6_3/m |
| 263 | BP | P6_3mc | 296 | ErCrTeO₆ | P-31c |
| 264 | BaAl₂(SiO₄)₂ | P-3 | 297 | TmCrTeO₆ | P-31c |
| 265 | Ca₂SiO₄ | P-3m1 | 298 | SmCrTeO₆ | P-31c |
| 266 | K₂Mg₂Si₂O₇ | P-31m | 299 | FeF₃ | P321 |
| 267 | Li₁₄P₂(N₂O)₃ | P-3 | 300 | GdCrTeO₆ | P-31c |
| 268 | Li₂PNO₂ | Cmc2_1 | 301 | NdCrTeO₆ | P-31c |
| 269 | LiGe₂N₃ | Cmc2_1 | 302 | PrCrTeO₆ | P-31c |
| 270 | K₂PdC₂ | P-3m1 | 303 | B₆O | R-3m |
| 271 | GeO₂ | Pnnm | 304 | MoS₂ | R3m |
| 272 | Na₂TcF₆ | P-3m1 | 305 | WS₂ | P6_3/mmc |
| 273 | Mg(BC)₂ | Pnnm | | | |

**[Table 3]**

| Chemical formula | Space group |
|---|---|
| GeO₂ | P4_2/mnm |
| PtO₂ | P-3m 1 |
| FeS₂ | Pnnm |
| BeAl₂O₄ | Pnma |
| K₂TiF₆ | P-3m1 |
| Mg₃(BO₃)₂ | Pnnm |
| K₂GeF₆ | P-3m1 |
| BeSiN₂ | Pna2_1 |
| K₂PdF₆ | P-3m1 |
| BN | P6_3/mmc |
| LiBC | P6_3/mmc |
| Mn₃(BO₃)₂ | Pnnm |
| TiPbO₃ | P4mm |
| PbO | Pbcm |
| MnO₂ | P-3ml |
| LiB₆C | Amm2 |
| InHO₂ | Pnnm |
| GaHO₂ | Pnma |
| Mg(BC)₂ | Pnnm |
| BeCr₂O₄ | Pnma |

**[Table 4]**

| Chemical formula | Space group | Chemical formula | Space group |
|---|---|---|---|
| TiO₂ | I4_1/amd | Al₂O₃ | R-3c |
| AlN | P6_3mc | FeBiO₃ | R3c |
| GaN | P6_3mc | Al₂ZnO₄ | Fd-3m |
| Be₂C | Fm-3m | MgAl₂O₄ | Fd-3m |
| Li₂O | Fm-3m | SiC | F-43m |
| ZnO | P6_3mc | RbMgF₃ | Pm-3m |
| BeO | P6_3mc | K₂CO₃ | P6_3/mmc |
| KMgF₃ | Pm-3m | K₂SiF₆ | P6_3mc |
| KTaO₃ | Pm-3m | Li₂GeO₃ | Cmc2_1 |
| BaAl₂O₄ | P6_322 | SrMnO₃ | P6_3/mmc |
| K₂TiF₆ | P-3m1 | CoO | P6_3mc |
| NaTaO₃ | Pm-3m | BaNiO₃ | P6_3mc |
| Li₂SiO₃ | Cmc2_1 | Na₂CO₃ | P6_3/mmc |
| SrTiO₃ | Pm-3m | NaMnO₂ | Pmmn |
| LaAlO₃ | Pm-3m | Al₂PbO₄ | Ama2 |
| BaTiO₃ | Amm2 | Li₈GeO₆ | P6_3cm |
| KZnF₃ | Pm-3m | K₂MnF₆ | P6_3mc |
| CsCu₃S₂ | P-3ml | KNbO₃ | Pm-3m |
| K₂GeF₆ | P-3m1 | Na₂TcF₆ | P-3m1 |
| K₂PdF₆ | P-3m1 | | |

The thickness of each of the antiferromagnetic body layer 11 and the second antiferromagnetic body layer 13 is, for example, 0.5 nm - 40 nm, preferably 0.5 nm - 30 nm, and more preferably 0.5 nm - 20 nm. The thickness of the insulator layer 12 is, for example, 0.5 nm - 5 nm, preferably 0.5 nm - 4 nm, and more preferably 1 nm - 3 nm. When each of the layers has such a thickness, the resistance value can be adjusted to a value appropriate for device application.

The inventors of the present disclosure have found, by performing a simulation as described below, that a relatively large TMR ratio can be obtained by using a specific material for the insulator layer according to the plane orientation of the surface of the antiferromagnetic body layer.

### (Simulation Method)

To search for a material suitable as an insulator layer of a tunnel magnetoresistive element, simulation was conducted in the following three steps.
(1) Search for materials having crystal planes with shapes close to those of Mn₃Sn, Mn₃Ge, Mn₃Ga, and Mn₃AₓB₁₋ₓ (A and B are each one selected from among Sn, Ge, and Ga; 0 < x < 1), which are materials of the antiferromagnetic body layer, being secured to have insulating properties, and being experimentally producible
(2) Among the materials searched above, search for materials having stable interfaces
(3) Among the materials searched above, search for materials having a large TMR ratio

Hereinafter, description will be made in order.
(1) Search for materials having crystal planes with shapes close to those of Mn₃Sn, Mn₃Ge, Mn₃Ga, and Mn₃AₓB₁₋ₓ (A and B are each one selected from among Sn, Ge, and Ga; 0 < x < 1), which are materials of the antiferromagnetic body layer, being secured to have insulating properties, and being experimentally producible

Crystal structures of materials disclosed in The Materials Project (https://materialsproject.org/) are acquired, and in each of the materials, a material in which there is a "crystal plane having a shape close" to each of a (10-10) plane and a (0001) plane of a hexagonal crystal to be used in the antiferromagnetic body layer is searched for. At this time, as the crystal structures of Mn₃Sn, Mn₃Ge, and Mn₃Ga of the antiferromagnetic body layer, those disclosed in The Materials Project are used, and as for Mn₃AₓB₁₋ₓ (A, B = Sn, Ge, Ga; 0 < x < 1), a weighted average for x of the crystal structures corresponding to atoms of A and B is used. The "crystal planes with shapes close to" shall be made to match by lattice-deforming the (10-10) plane and the (0001) plane of any of Mn₃Sn, Mn₃Ge, Mn₃Ga, and Mn₃AₓB₁₋ₓ within certain ranges. The (10-10) plane and the (0001) plane are parallelograms, and sides of lengths a and b (a < b) are connected at an angle θ. Here, assuming the deformation of a, b → a × (1 + p) and b × (1 + q), the range of the lattice deformation is set to -0.07 < p, q < 0.07, and -0.07 < p + q < 0.07. The angle θ is assumed to be deformed within ±3.5%.

From among the materials searched as described above, materials are selected with the proviso that the materials are composed of 2, 3, or 4 types of constituent atoms; in order to secure insulation properties, the band gap is 0.5 eV or more, the formation energy is negative, and the energy above the convex hull value is 0.15 eV/atom or less; and the materials are registered in ICSD (Inorganic Crystal Structure Database).

### (2) Among the materials searched above, search for materials having stable interfaces

Simulation calculation is conducted for each of the insulators in Tables 1 and 2 obtained in the above (1), for the case of selecting at least one from among Mn₃Sn, Mn₃Ge, Mn₃Ga, and Mn₃AₓB₁₋ₓ to create a two layer structure of insulator layer/magnetic body layer/vacuum surface. Here, the surface to be laminated is the (10-10) plane of the magnetic body layer for the insulators of Table 1 and the (0001) plane of the magnetic body layer for the insulators of Table 2. To optimize the structure in the vicinity of the interface in the two layer structure, the first principle calculation is used to set the distance between layers and the position of the lamination surface of the layer so as to minimize the energy, and then the local structure optimization of the internal coordinates of atoms in two - four layer in the vicinity of the interface is conducted.

The interface energy in the two layer structure obtained as described above is determined by the first principle calculation. This makes it possible to clarify an insulator capable of stably forming an interface with an antiferromagnetic body layer. In the calculation of the interface energy, in addition to the two layer structure, the energy of each of the structure of the insulator alone, the magnetic body alone, the surface of the insulator, and the surface of the magnetic body is determined and subtracted from the two layer structure, and thus the interface energy is obtained. Here, the thickness of each layer is set to 0.8 nm or more.

These energies and optimal interface structures are calculated by the first principle calculation code: Quantum ESPRESSO (QE) (see P. Giannozzi, et al., J. Phys.: Condensed Matter 21, 395502 (2009)). The generalized gradient approximation by Perdew-Burke-Ernzerhof (PBE) was used for the exchange-correlation functional in the framework of the ultra-soft pseudopotential (USPP) method (see, for example, G. Kresse and D. Joubert, Phys. Rev. B 59, T 1758 (1999)). The USPP was obtained from the QE website (see https://www.quantum-espresso.org/). The energy cutoffs of the wave function and the charge density were set to 50 - 80 Ry and 80 - 800 Ry, respectively. These calculations were conducted under non-magnetic conditions.

A material whose interface energy obtained as described above is 2 J/m² or less is determined to be an insulator material capable of stably forming a laminated structure with a magnetic body.

### (3) Among the materials searched above, search for materials having a large TMR ratio

A structure of insulator layer/magnetic body layer A/insulator layer/magnetic body layer B prepared by repeating the above-described two layer structure twice with removal of the vacuum layer is to be used for the simulation. A periodic boundary condition is imposed on the resulting four layer structure, and the tunnel conductivity is calculated in consideration of magnetism to estimate a TMR ratio. To theoretically simulate the TMR ratio from the first principle, a PWCOND package of a QE package was used which calculates the ballistic transport along the lamination direction (z-direction) by solving the scattering problem on the Bloch wave function obtained by the DFT calculation. The k = (kx, ky) point mesh on the xy plane was set to 32 × 32 to 64 × 64, and the transmittance T was calculated for each relative angle between the magnetic arrangements (cluster magnetic octupole moments of the two magnetic layers). This is the maximum value (minimum value) of the transmittance. Using Tmax (min), TMR can be evaluated by (Tmax - Tmin)/Tmin.

From these simulation calculations, it has been found that, in a tunnel magnetoresistive element, in the case where the plane orientation of a surface of an antiferromagnetic body layer 11 in contact with an insulating layer is a (10-10) plane, when the insulating layer laminated on the (10-10) plane is as shown in Table 1, and in the case where the plane orientation of a surface of an antiferromagnetic body layer 11 in contact with an insulating layer is a (0001) plane, when the insulating layer laminated on the (0001) plane is as shown in Table 2, the TMR ratio is relatively large.

In one embodiment of the present disclosure, the band gap of the compound contained in the insulator layer is 0.5 eV or more, 0.8 eV or more in a more preferred embodiment, and 1.5 eV or more in a still more preferred embodiment.

In one embodiment of the present disclosure, the compound contained in the insulator layer has a negative formation energy and an energy above the convex hull value of 0.15 eV/atom or less. In a more preferred embodiment, the compound contained in the insulator layer has an energy above the convex hull value of 0.02 eV/atom or less.

In one embodiment of the present disclosure, the interface energy of the interface of the two layer film of the magnetic body and the insulator determined by the first principle calculation is 2 J/m² or less. In a more preferred embodiment, the interface energy of the interface of the two layer film of the magnetic body and the insulator determined by the first principle calculation is 1 J/m² or less.

In one embodiment of the present disclosure, the tunnel magnetoresistive element has a TMR ratio of 300% or more. In a more preferred embodiment, the TMR ratio of the tunnel magnetoresistive element is 1000% or more.

In one embodiment of the present disclosure, the insulator layer and the two antiferromagnetic body layers are in direct contact. In another embodiment, one or more other layers are interposed between the insulator layer and the antiferromagnetic body layer. The other layer disposed between the antiferromagnetic body layer and the insulator layer may be any layer that can be formed by a publicly known film forming means such as sputtering or epitaxial growth (MBE, MOCVD, etc.) and is not particularly limited. Examples of one or more other layers in this case include a layer containing Ta or Ru as a material.

### [Method for producing two layer film of magnetic body and insulator and tunnel magnetoresistive element]

The two layer film of a magnetic body and an insulator and the tunnel magnetoresistive element can be formed by the procedure including (1) formation of an antiferromagnetic body layer 11, (2) lamination of an insulator layer 12 on the antiferromagnetic body layer 11, and (3) lamination of a second antiferromagnetic body layer 13 on the insulator layer 12. Hereinafter, the method will be specifically described.

### (1) Formation of antiferromagnetic body layer 11

The antiferromagnetic body layer 11 can be formed by forming a film of the material of the present disclosure on a substrate to be an electrode by a publicly known film forming means such as sputtering or epitaxial growth (MBE, MOCVD, etc.).

When sputtering is used, examples of a target material include Mn3Sn.

Examples of the material of the substrate to be an electrode (the substrate electrode layer) include W, Pt, and Ta, and the thickness thereof is typically 1 nm - 20 nm, and preferably 1 nm - 5 nm.

### (2) Lamination of insulator layer 12 on antiferromagnetic body layer 11

Next, the insulator layer 12 is formed on the antiferromagnetic body layer 11 by a publicly known film forming means such as sputtering. When sputtering is used, an oxide, nitride, oxynitride, or the like of metal can be used as a target material. Sputtering that is reactive under an oxygen or nitrogen atmosphere may also be used.

### (3) Lamination of second antiferromagnetic body layer 13 on insulator layer 12

Next, the antiferromagnetic body layer 13 can be formed by forming a film of the material of the present disclosure on the insulator layer 12 by a publicly known film forming means such as epitaxial growth (MBE, MOCVD, etc.).

When sputtering is used, examples of a target material include Mn3Sn similarly to the antiferromagnetic body layer 11.

### [Operation of tunnel magnetoresistive element]

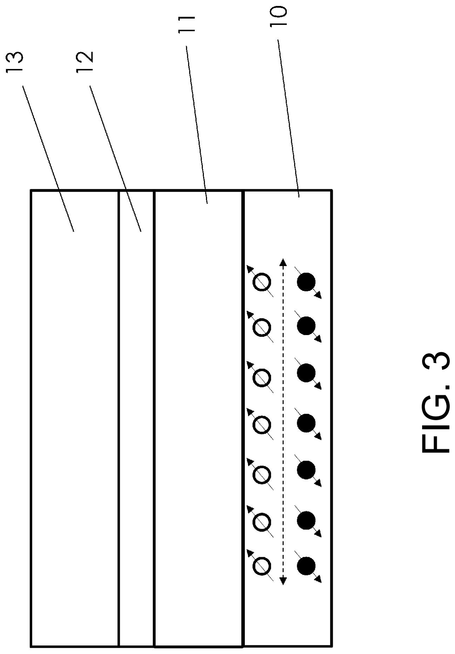

Fig. 3 is a cross-sectional view illustrating one embodiment of a tunnel magnetoresistive element. On the substrate electrode layer 10, an insulator layer 12 and a second antiferromagnetic layer 13 are laminated in this order on the surface of the antiferromagnetic body layer 11. Here, examples of the material of the substrate electrode layer 10 include W, Pt, and Ta as spin current generating materials.

The net spin polarization direction of the first antiferromagnetic layer is preferably perpendicular to the antiferromagnetic body layer 11, but may be inclined. In this tunnel magnetoresistive element, the electric resistance changes depending on the relative angle between the spin polarization direction of the antiferromagnetic body layer 11 and the spin polarization direction of the second antiferromagnetic body layer 13. Therefore, by rotating the spin polarization direction of the antiferromagnetic body layer 11, it is possible to switch between the low resistance state and the high resistance state. It is possible to make such a tunnel magnetoresistive element function as a storage cell by using a difference in resistance value before and after the switching as storage information.

For example, when a current flows in a layer parallel direction (for example, in a horizontal broken line arrow direction in Fig. 3) in the substrate electrode layer 10, a spin current is generated in a direction orthogonal to the current by spin-orbit interaction (this phenomenon is a spin Hall effect), and a magnetic torque is generated in the antiferromagnetic body layer 11. By changing the current direction in the substrate electrode layer 10, spin polarization direction rotation is caused in the antiferromagnetic body layer 11.

As described above, the antiferromagnetic body layer 11 and the second antiferromagnetic body layer 13 may be formed of the same material or may be formed of different materials. From the viewpoint of increasing the difference between the low resistance state and the high resistance state, the spin polarization direction of the antiferromagnetic body layer 11 and the spin polarization direction of the second antiferromagnetic body layer 13 are preferably directed in planes parallel to each other. That is, if the spin polarization direction of the antiferromagnetic body layer 11 is substantially perpendicular to the layer direction, it is preferable that the spin polarization direction of the second antiferromagnetic layer 13 is also substantially perpendicular to the layer direction, and if the spin polarization direction of the first antiferromagnetic layer 11 is substantially parallel to the layer direction, it is preferable that the spin polarization direction of the second antiferromagnetic layer 13 is also substantially parallel to the layer direction.

In the tunnel magnetoresistive element of the present disclosure, a relatively large TMR ratio can be obtained by using a specific material for the insulator layer according to the plane orientation of the surface of the antiferromagnetic body layer.

### [Magnetic memory]

A magnetic memory can be configured by using a plurality of the tunnel magnetoresistive elements described above as storage cells. A publicly known configuration can be used for the magnetic memory. For example, the structures of the magnetic memories described in US 2022/0149269 A and US 2019/0267540 A can be used. The descriptions of US 2022/0149269 A and US 2019/0267540 A regarding the structure of a magnetic memory are incorporated herein.

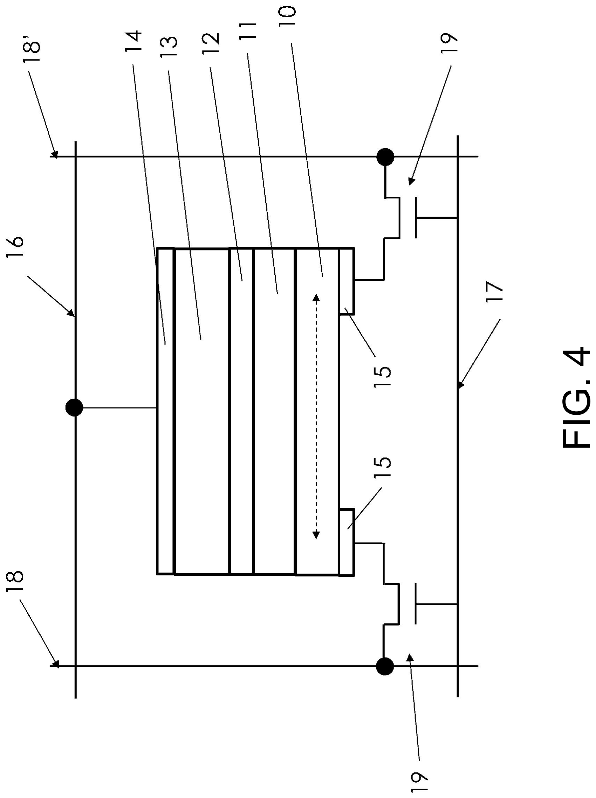

Fig. 4 is a circuit diagram illustrating one embodiment of wiring of a storage cell constituting a part of the magnetic memory of the present disclosure. The storage cells as illustrated in Fig. 4 are arranged in a matrix and driven.

In each storage cell, the insulator layer 12 and the second antiferromagnetic body layer 13 are laminated in this order on the surface of the antiferromagnetic body layer 11 laminated on the substrate electrode layer 10 to form a tunnel magnetoresistive element. The operation of this tunnel magnetoresistive element is similar to that described above for the tunnel magnetoresistive element.

The substrate electrode layer 10 is provided with two power supply electrodes 15 and 15, and the power supply electrodes 15 and 15 are connected to the sources of transistors 19 and 19, respectively. The gates of the transistors 19 and 19 are connected to a word line 17, and the drains of the two transistors 19 and 19 are connected to a first write bit line 18 and a second write bit line 18', respectively. The second antiferromagnetic body layer 13 is connected to a read bit line 16 via the electrode 14.

Here, in the case of switching data by changing the resistance value, to make one data state, the first write bit line 18 is set to H level, and the second write bit line 18' is set to L level. Then, when the word line 17 is set to H level, a current flows in the substrate electrode layer 10 from the first write bit line 18 toward the second write bit line 18', so that the spin polarization of the antiferromagnetic body layer 11 falls into a state corresponding to the current, and this is one data state.

When the data is switched, the first write bit line 18 is set to L level, and the second write bit line 18' is set to H level. Then, when the word line 17 is set to H level, the current flows in the substrate electrode layer 10 from the second write bit line 18' toward the first write bit line 18, so that the spin polarization of the antiferromagnetic body layer 11 changes, and the data is switched.

When the data stored in the storage cell is read, one of the first write bit line 18 and the second write bit line 18' is set to H level and the other is opened. Then, when the read bit line 16 is set to L level and the word line 17 is set to H level, a current flows from the first write bit line 18 and the second write bit line 18' toward the read bit line 16. Therefore, by measuring the magnitude of the current, it is determined whether the storage cell is in the high resistance state or the low resistance state, and data written in the storage cell is acquired.

In one embodiment of the magnetic memory, by arranging the storage cells as shown in Fig. 4 on a matrix, and controlling the levels of the write bit lines, the read bit lines, and the word line by a controller, a prescribed write/read operation is conducted.

In the magnetic memory of the present embodiment, a relatively large read signal can be obtained by using a specific material for the insulator layer according to the plane orientation of the surface of the antiferromagnetic body layer.

Obviously, numerous modifications and variations of the present invention are possible in light of the above teachings. It is therefore to be understood that within the scope of the appended claims, the invention may be practiced otherwise than as specifically described herein.

### INDUSTRIAL APPLICABILITY

The two layer film of a magnetic body and an insulator of the present disclosure is useful for obtaining a tunnel magnetoresistive element, and the tunnel magnetoresistive element is useful for obtaining a magnetic memory.

### DESCRIPTION OF REFERENCE SIGNS

- 10: Substrate electrode layer
- 11: Antiferromagnetic body layer
- 12: Insulator layer
- 13: Second antiferromagnetic body layer
- 14: Electrode
- 15: Power supply electrode
- 19: Transistor
- 17: Word line
- 18: First write bit line
- 18': Second write bit line
- 16: Read bit line

## Claims

1. A two layer film of a magnetic body and an insulator, comprising: an antiferromagnetic layer having a hexagonal crystal structure and having at least one plane being a (10-10) plane of an antiferromagnetic body; and an insulator layer laminated on the (10-10) plane and containing a compound composed of two, three, or four types of atoms.

2. A two layer film of a magnetic body and an insulator, comprising: an antiferromagnetic layer having a hexagonal crystal structure and having at least one plane being a (0001) plane of an antiferromagnetic body; and an insulator layer laminated on the (0001) plane and containing a compound composed of two, three, or four types of atoms.

3. The two layer film of a magnetic body and an insulator according to claim 1, wherein the compound comprises at least one selected from among BeTe, YbSe, PbF₂, GeO₂, PtO₂, ThO₂, Surfs, BN, LiF, Li₂S, ZnSe, MgO, PtO₂, BaO, LiC, CaSe, TiO₂, FeS₂, BN, CaS, YbS, AlAs, Li₂Se, CdS, BeO, BN, CaF₂, BeAl₂O₄, NaNbO₃, SrZrO₃, KMgF₃, KTaO₃, K₂PtF₆, BaZrO₃, Mg₂PN₃, K₂TiF₆, KCuO₂, NaTaO₃, KNbO₃, NaNbO₃, SrHfO₃, NaTaO₃, Na₂PdC₂, Mg₃(BO₃)₂, Li₂SiO₃, BaTiO₃, SrTiO₃, KNbO₃, BaTiO₃, CaTiO₃, LiSi₂N₃, KZnF₃, TiCoSb, BaTiO₃, LiSiNO, KNbO₃, BeO, Mg₃NF₃, SbOF, ZnF₂, K₂ReF₆, K₂GeF₆, BeSiN₂, K₂PdF₆, BN, HgF₂, MgAlBO₄, TeO₂, RbMgF₃, KF, Li₃BN₂, LiZnAs, LiBC, NbFeSb, LiZnP, BaLiF₃, ScF₃, GeO₂, NbAgO₃, Li₃PO₄, ZnAgF₃, BeF₂, LaCrO₃, MgWO₄, ZnWO₄, NiO, NdCrO₃, Mn₃(BO₃)₂, FeWO₄, WO₃, TiPbO₃, TiPbO₃, NaVF₃, PbO, NiWO₄, HfPbO₃, NaCl, CsCl, TlBr, LiI, NaBr, AgCl, AgBr, RbCl, RbBr, SrH₂, H₄CN₂O, GaHO₂, LiHO, CrHO₂, MnO₂, LuSBr, ErSCl, K₂PdF₄, RbH₃O₂, ErSeI, Li₃BrO, DySBr, DySI, UCO₅, InHO₂, FeHO₂, NiO₂, SnO, KNO₂, SrSnO₃, LaFeO₃, MoF₃, RbNa₂AuO₂, KMnF₃, UCO₅, CoF₂, GdSI, RbVF₃, Li₂CO₃, FeF₂, KVF₃, KrF₂, KNa₂AuO₂, ScF₃, NaMgF₃, SeO₂, KCrF₃, LiB₆C, AgBr, SrAlSiH, KBr, BaAlSiH, InHO₂, GaHO₂, Ba₂MgH₆, HgH₂NCl, Sr₂MgH₆, BN, KNbO₃, SrAlGeH, KH₄O₂F, CuI, TiGePt, HoSI, Li₂PNO₂, ZrPbO₃, GeO₂, CO₂, Na₂TcF₆, Mg(BC)₂, K₂TcF₆, GeF₂, ZnMoO₄, LaGaO₃, LaF₃, BaBClF₄, BaGaH₅, SrH₂, SrHN, BeCr₂O₄, and BaAlGeH.

4. The two layer film of a magnetic body and an insulator according to claim 1, wherein the compound comprises at least one selected from among GeO₂, PtO₂, FeS₂, BeAl₂O₄, K₂TiF₆, Mg₃(BO₃)₂, K₂GeF₆, BeSiN₂, K₂PdF₆, BN, LiBC, Mn₃(BO₃)₂, TiPbO₃, PbO, MnO₂, LiB₆C, InHO₂, GaHO₂, Mg(BC)₂, and BeCr₂O₄.

5. The two layer film of a magnetic body and an insulator according to claim 2, wherein the compound comprises at least one selected from among TiO₂, AlF₃, GeO₂, PtO₂, AIN, NaF, GaN, BN, LiF, YbO, MgO, BP, Be₂C, BN, Li₂O, ZnO, ZnO, ZnO, BeO, BN, TiO₂, LuPO₄, AlCuO₂, NaNbO₃, Na₂SO₄, Li₂ZrN₂, KMgF₃, KTaO₃, ScCuO₂, NaNbO₂, K₂PtF₆, BaAl₂O₄, LiNbO₂, Mg₂PN₃, K₂TiF₆, ErPO₄, HoPO₄, NaTaO₃, Ge₂N₂O, ScPO₄, TbPO₄, KNbO₃, TlNO₂, Si₂N₂O, Cd₂SiO₄, BaCO₃, HfSiO₄, TaBO₄, Li₂SiO₃, BaTiO₃, YPO₄, AlAsO₄, SrTiO₃, KNbO₃, LaAlO₃, AlPO₄, DyPO₄, BaTiO₃, CaTiO₃, LiScO₂, LiSi₂N₃, KZnF₃, TmPO₄, BaTiO₃, LiCaAlF₆, KLiSO₄, KLiBeF₄, KLiSO₄, LiAlSiO₄, SrLiAlF₆, KLiSO₄, SiO₂, Be₃N₂, SiO₂, SiC, KNbO₃, InPO₄, BeO, SiO₂, CsCu₃S₂, K₂GeF₆, PtO₂, K₂PdF₆, BN, AlF₃, SiC, NaBe₄SbO₇, NaHgPO₄, KAlSiO₄, RbMgF₃, CsF, CdSO₄, NbBO₄, Cd(SbO₃)₂, PtF₄, NaSi₂N₃, Ca₂PN₃, LiAlPdF₆, Ca(SbO₃)₂, Sr(SbO₃)₂, Ba(SbO₃)₂, TiO₂, LiBC, KAlSiO₄, Li₂CN₂, LiYbAlF₆, BaLiF₃, Zn(ReO₄)₂, Na₂GeTeO₆, SrGeTeO₆, K₂CO₃, ScF₃, SiO₂, Rb₂PdC₂, Rb₂PtC₂, Mg(BeN)₂, MgSeO₄, NbAgO₃, LiCaGaF₆, K₂SiF₆, TlPO₄, Al₄CO₄, ZnAgF₃, K₂GeF₆, NaGe₂N₃, Li₂GeO₃, AlTl(MoO₄)₂, RbLiCrO₄, Na₂CrO₄, CrCdO₄, Cr₂SiO₄, NiSeO₄, LaCrO₃, BaNiO₂, SrMnO₃, NiO, Na₂FeO₄, NdCrO₃, LiMnVO₄, FePO₄, MgCrO₄, CoO, BaNiO₃, K₃NaCr₂O₈, BaNiO₃, RbLiCrO₄, Li₂WO₄, Li₂MnO₂, NaCaVO₄, Li₂NiO₂, KAl(MoO₄)₂, PrCrO₃, CrHgO₄, WO₃, VCrO₄, NaVCdO₄, TiPbO₃, NdCoO₃, Na₂CO₃, Ga₂PbO₄, Sb₂PbO₆, NaMnO₂, RhF₃, Na₂SO₃, Al₂PbO₄, Na₂PtO₂, BaSr(FeO₂)₄, VInO₄, K₃Na(SO₄)₂, SmCoO₃, TlBr, LiIO₃, KAs₄BrO₆, KAs₄IO₆, TlCl, KCl, RbCl, Mg(AlH₄)₂, Mg₃Si₂H₄O₉, Mn(HO)₂, GaHO₂, ZrP₂(HO₃)₂, CrHO₂, MnO₂, Li₈CoO₆, K₂PdF₄, Li₈GeO₆, Li₈SiO₆, Li₃BrO, BaReH₉, CsAl(MoO₄)₂, Cs₂PdC₂, Cs₂PtC₂, MnVCuO₄, NiO₂, BaCO₃, AlPO₄, RbGeIO₆, MgO, KNiIO₆, CoSeO₄, LaFeO₃, CsCu₃O₂, K₂Al₂Sb₂O₇, Na₅MoNO₄, Li₂Mn₂NiO₆, LiCaCoF₆, SiO₂, MnSeO₄, KNaSO₄, SiO₂, KAs₄ClO₆, Rb₂Al₂Sb₂O₇, LiCaCrF₆, Li₂SO₄, KNaSO₄, LiAlSiO₄, SiO₂, ScF₃, Al₂O₃, FeBiO₃, Al₂ZnO₄, MgAl₂O₄, LiCoO₂, LaGaO₃, Si(NiO₂)₂, Mg₂SiO₄, MoS₂, FeCuO₂, MoSe₂, Sr₃(PO₄)₂, K₂S, PNF₂, K₂MnF₆, AlPO₄, LiMgVO₄, NaMgF₃, BaZr(PO₄)₂, CaCO₃, Na₄CoAuO₅, GdBO₃, Li₄Ca₃(SiN₃)₂, FeP₄, LiB₆C, FeP₄, Ga₂Os, KBr, GaHO₂, ZrP₂(HO₃)₂, Ba₃(H₆Ir)₂, Ba₂MgH₆, GaH₃NF₃, Sr₂MgH₆, BN, TiHs(NF₃)₂, Rb₂S, MgMoN₂, NaCoO₂, KNbO₃, SiO₂, K₄Hf₅O₁₂, K₂PtC₂, BP, BaAl₂(SiO₄)₂, Ca₂SiO₄, K₂Mg₂Si₂O₇, Li₁₄P₂(N₂O)₃, Li₂PNO₂, LiGe₂N₃, K₂PdC₂, GeO₂, Na₂TcF₆, Mg(BC)₂, KCrO₂, ScAlCO, K₂TcF₆, CsFe(MoO₄)₂, LaGaO₃, VO₂, Zn₂PN₃, AlF₃, Sr₃Ta₂ZnO₉, Sr₃MgTa₂O₉, MgVCuO₄, Rb₃Lu(PO₄)₂, Rb₃Er(PO₄)₂, CaH₂F₄, BaCo₂(PO₄)₂, Li₂H₆PtO₆, LaCrTeO₆, YCrTeO₆, TbCrTeO₆, DyCrTeO₆, HoCrTeO₆, YbH₃CN₃, ErCrTeO₆, TmCrTeO₆, SmCrTeO₆, FeF₃, GdCrTeO₆, NdCrTeO₆, PrCrTeO₆, B₆O, MoS₂, and WS₂.

6. The two layer film of a magnetic body and an insulator according to claim 2, wherein the compound comprises at least one selected from among TiO₂, AlN, GaN, Be₂C, Li₂O, ZnO, BeO, KMgF₃, KTaO3, BaAl₂O₄, K₂TiF₆, NaTaO₃, Li₂SiO₃, SrTiO₃, LaAlO₃, BaTiO₃, KZnF₃, CsCu₃S₂, K₂GeF₆, K₂PdF₆, Al₂O₃, FeBiO₃, Al₂ZnO₄, MgAl₂O₄, SiC, RbMgF₃, K₂CO₃, K₂SiF₆, Li₂GeO₃, SrMnO₃, CoO, BaNiO₃, Na₂CO₃, NaMnO2, Al₂PbO₄, Li₈GeO₆, K₂MnF₆, KNbO₃, and Na₂TcF₆.

7. A tunnel magnetoresistive element comprising the two layer film of a magnetic body and an insulator according to claim 3 and a second antiferromagnetic film layer laminated on the insulator of the two layer film.

8. A tunnel magnetoresistive element comprising the two layer film of a magnetic body and an insulator according to claim 4 and a second antiferromagnetic film layer laminated on the insulator of the two layer film.

9. A magnetic memory comprising a plurality of the tunnel magnetoresistive elements according to claim 7.

10. A magnetic memory comprising a plurality of the tunnel magnetoresistive elements according to claim 8.
